# EUROPEAN PATENT APPLICATION

(11) **EP 1 403 917 A1**
(43) Date of publication of application: **31.03.2004**
(21) Application number: 02425581.2
(22) Date of filing: 26.09.2002
(51) Int. Cl.: H01L 21/762

(54) **Process for manufacturing semiconductor wafers incorporating differentiated isolating structures**

(71) Applicant: STMicroelectronics S.r.l., 20041 Agrate Brianza (Milano) (IT)
(72) Inventor: Brazzelli, Daniela, 21052 Busto Arsizio (IT); Clementi, Cesare, 21052 Busto Arsizio (IT)
(74) Representative: Cerbaro, Elena

(57) **Abstract**

A process for manufacturing semiconductor wafers incorporating differentiated insulating structures envisages the steps of: opening first trenches (8) in a substrate (2) of a semiconductor wafer (1), the trenches delimiting first conductive regions (9) and having a first depth; and opening second trenches (16), delimiting second conductive regions (17) and having a second depth. Furthermore, the step of opening second trenches (16) is preceded by the step of forming first insulating sidewalls (12), which surround the first trenches (8), and is followed by the step of forming second insulating sidewalls (19), which surround the second trenches (16) .

## Description

The present invention relates to a process for manufacturing semiconductor wafers incorporating differentiated insulating structures.

The invention finds advantageous application especially in the production of nonvolatile-memory cells of the so-called "superimposed-gate" type.

As is known, in one and the same device it is often necessary to integrate circuits having very different characteristics, e.g., as regards operating voltages and currents, consumption requirements, speed, noise, etc. In order to optimize performance of these circuits, it is expedient to isolate, in a differentiated way, the active areas where the circuits are made. For example, in the case of nonvolatile memories of a flash type, to which reference will be made hereinafter, in one and the same semiconductor wafer both an array of memory cells and decoding and read/write circuits are manufactured. In "A 130nm Generation High Density Etox™ Flash Memory Technology" by S. N. Keeney, in "Proceedings IEDM 2002", it has been proposed to isolate the active areas designed to house the cells and the circuitry using trenches of different depths and widths filled with a dielectric material, such as silicon dioxide (the so-called "Shallow-Trench Isolation", STI). In particular, the array active areas are isolated by trenches of smaller depth, so as to be able to obtain low-resistance source lines, whereas the active areas housing the circuitry are isolated by deeper trenches, so as to limit the effects of parasitic components and prevent breakdown.

To obtain structures of this type, in a semiconductor wafer, normally of monocrystalline silicon, trenches of two different depths are made separately to delimit the array active areas and the circuitry active areas. The walls of the trenches are then thermally oxidized, before the trenches are filled up with silicon dioxide. The oxidation step following the opening of the trenches is very important, since it enables rounding the top corners and possibly the bottom corners of the trenches. Better quality oxides are thus obtained. In fact, any possible asperities of the surface of the silicon prior to growth of the oxides may cause a thinning-out of the oxides themselves and/or localization of the electric field (point effect). Furthermore, the likelihood that release of mechanical stresses due to thermal stresses during fabrication will cause dislocations or other crystallographic defects is reduced.

However, known processes have some limits, which prevent the production of devices having small overall dimensions. In fact, isolation of circuitry active areas requires that a rather thick oxide layer (from 25 to 50 nm) will be formed on the sidewalls of the trenches. However, this thickness is not compatible with the sizes of the array active areas (approx. 100 nm), since the thermal-oxide layer grows also inside the silicon, consuming it. In other words, considerably extensive regions of silicon must be initially delimited by trenches, in order to obtain array active areas of the envisaged dimensions. During thermal oxidation, which is necessary for insulating the circuitry active areas, the said regions are partially consumed, and the array active areas are reduced in amplitude. Otherwise, the reduction of the array active areas would be excessive and would not enable subsequent creation of the memory cells. On the other hand, the geometry of the trenches which delimit the array active areas, of smaller depth, is not normally so critical as to require thick oxide layers.

Known processes cannot therefore be used for fabricating compact devices, although the reduction in size is an increasingly important objective in microelectronics.

The purpose of the present invention is to provide a process for fabricating semiconductor wafers that incorporate differentiated insulating structures, which will be free from the drawbacks described above.

According to the present invention, a process for fabricating semiconductor wafers that incorporate differentiated insulating structures is provided, as defined in claim 1.

For a better understanding of the present invention, there is now described an embodiment thereof, provided purely by way of non-limiting example and with reference to the annexed drawings, in which:
- Figures 1 to 11 are cross-sectional views through a semiconductor wafer in successive fabrication steps of a process according to a first embodiment of the present invention; and
- Figure 12 is a cross-sectional view through a semiconductor wafer in an intermediate fabrication step of a process according to a different embodiment of the present invention.

Reference will be made hereinafter to a fabrication process of a flash memory; however, this is not to be considered in any way limiting, since the invention can equally be used for making devices of other kinds.

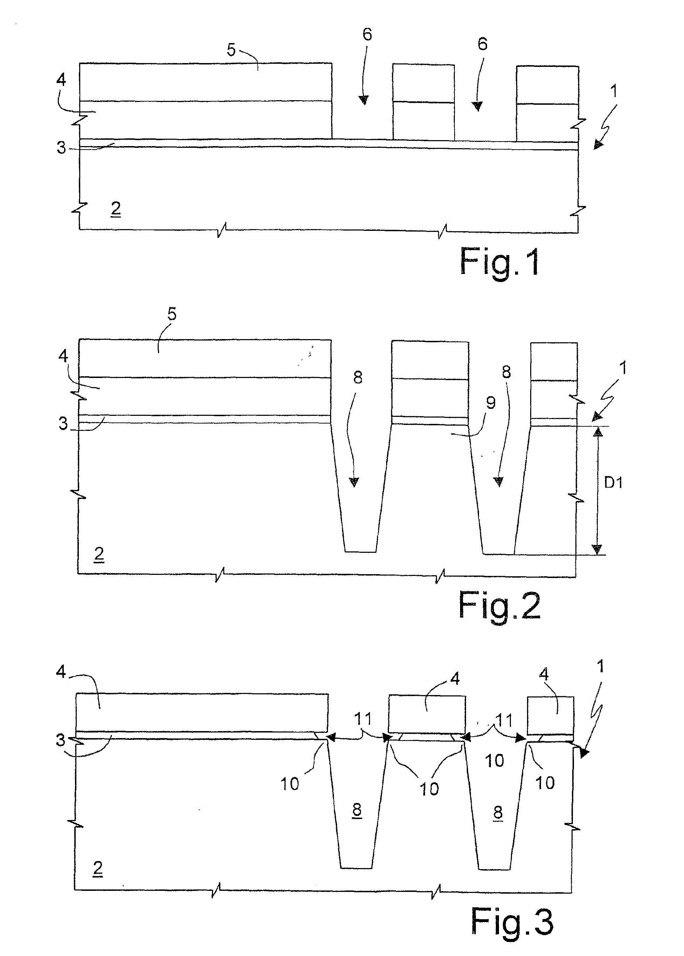

As is illustrated in Figure 1, on a semiconductor wafer 1, having a substrate 2, for example, of monocrystalline silicon, a protective structure is initially formed comprising a pad-oxide layer 3, on which a silicon-nitride layer 4 is deposited. The silicon-nitride layer 4 is anisotropically etched, using a first resist mask 5, and first openings 6 are made.

Subsequently (Figure 2), exposed portions of the pad-oxide layer 3 are removed, and the substrate 2 is etched via a first deep trench etch through the first openings 6. In this step, circuitry trenches 8 with inclined profile are opened, which delimit a circuitry active area 9 and have a first depth D1, preferably between 220 nm and 400 nm. After the trench etch, the first mask 5 is removed.

A so-called "undercut" step is then carried out on the pad-oxide layer 3, as shown in Figure 3. In practice, in this step, the pad-oxide layer 3 is etched in acid environment, for example in HF, and is partially removed underneath the silicon-nitride layer 4, where gaps 11 are formed. The top corners 10 of the circuitry trenches 8 are thus left exposed.

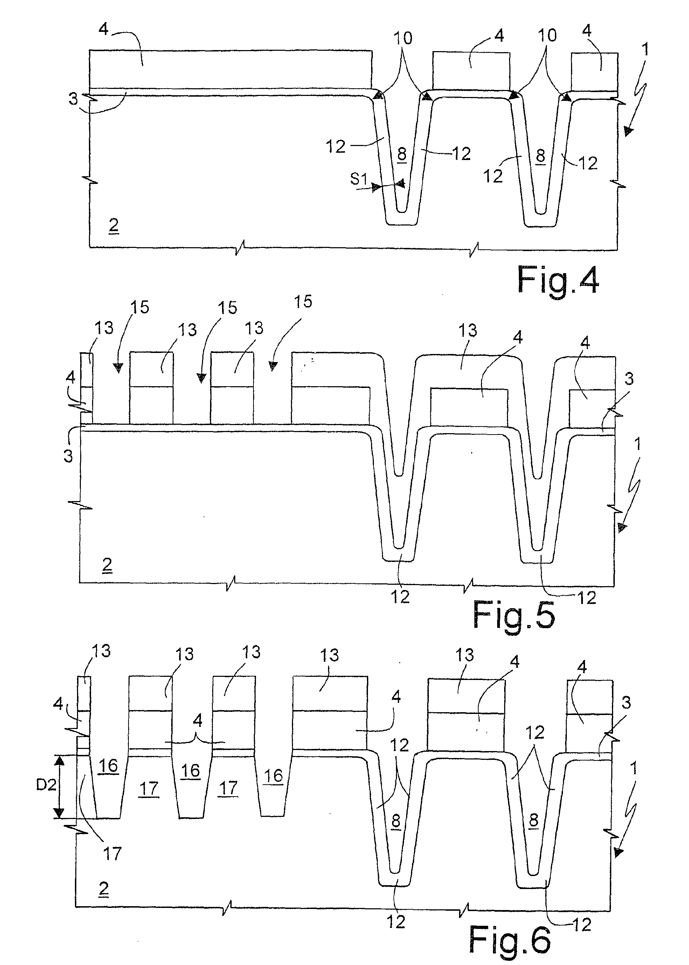

By a first thermal oxidation, first silicon-dioxide sidewalls 12 are formed around the circuitry trenches 8 (Figure 4). In detail, the first sidewalls 12 grow gradually in part inside the circuitry trenches 8 and in part in the substrate 2, until a predetermined first thickness S1 is reached. The thickness S1 is preferably between 25 nm and 50 nm and is, for example, approximately 40 nm. In addition, during the first thermal oxidation, which can be carried out in the presence of HCl and in either wet or dry environment, the top corners 10, previously uncovered, are easily oxidized and rounded, thus filling the gaps 11. Likewise, the first sidewalls 12 are rounded on the floor of the circuitry trenches 8. Both the first thickness S1 of the first sidewalls 12 and the rounding degree can be controlled in a way in itself known. First trench isolation structures are thus made comprising the circuitry trenches 8 and the first sidewalls 12.

With reference to Figure 5, a second resist mask 13, which covers the wafer 1 by partially filling the circuitry trenches 8, is formed.

After the uncovered portions of the silicon-nitride layer 4 and the underlying portions of the pad-oxide layer 3 have been selectively removed via anisotropic etch, thus forming second openings 15, a second trench etch is carried out. As illustrated in Figure 6, in this step, through the second openings 15, array trenches 16 delimiting a plurality of array active areas 17 are opened. The array trenches 16 have an inclined profile and are less deep than the circuitry trenches 8; for example, the array trenches 16 have a second depth D2 preferably of between 100 and 200 nm. The second resist mask 13 is then removed.

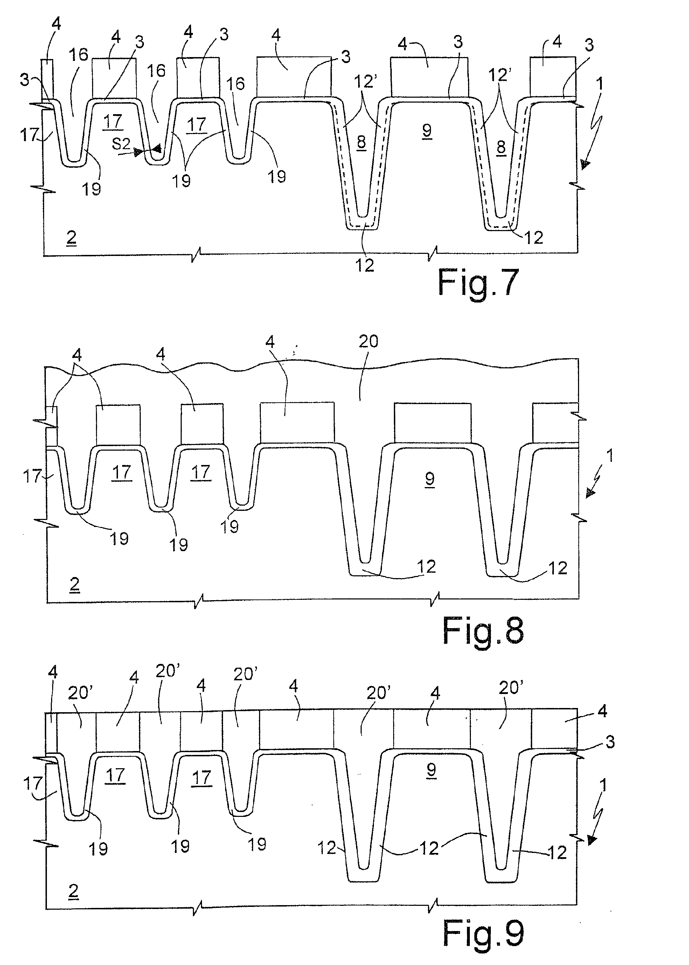

Next, with reference to Figure 7, a second thermal oxidation for forming second sidewalls 19 around the array trenches 16 is carried out. Also in this case, thermal oxidation can occur in the presence of HCl and in either wet or dry environment. The second sidewalls 19 are thinner than the first sidewalls 12 and have, for example, a second thickness S2 of approximately 10 nm. Furthermore, also the second sidewalls 19 are rounded both at the mouth and on the floor of the array trenches 16. In particular, the second thermal oxidation is carried out so as to optimize rounding and the second thickness S2 of the second walls 19. Second trench isolation structures are thus made, which comprise the array trenches 16 and the second sidewalls 19. Furthermore, in this step, also the thickness of the first sidewalls 12, which remain exposed once again after the second mask 13 has been removed, increases slightly. In practice, on the first sidewalls 12 a growth layer 12' is formed, which extends within the substrate 2. A further step of thermal annealing may be envisaged for further recovery of any possible imperfections due to previous fabrication steps.

Isolation of the circuitry active areas 9 and of the array active areas 17 is completed by filling the circuitry trenches 8 and the array trenches 16 with at least one insulating layer 20 of deposited silicon dioxide, as illustrated in Figure 8. The wafer 1 is then planarized using a chemical-mechanical-polishing (CMP) technique so as to obtain a uniform surface (Figure 9) .

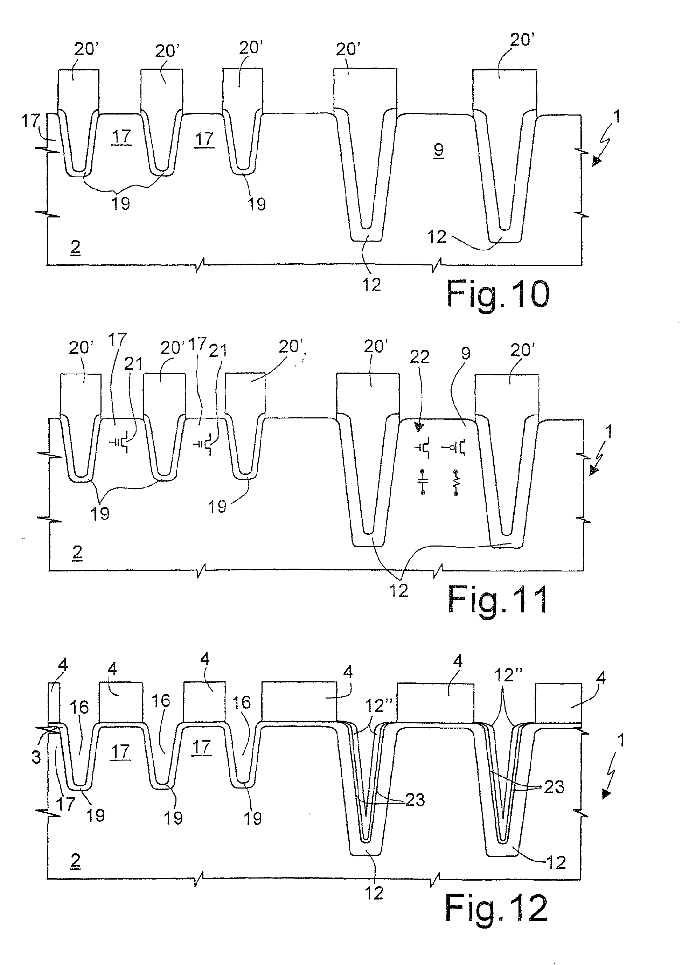

The silicon-nitride layer 4 is then etched, and portions of the pad-oxide layer 3, which in this way remain uncovered, are selectively removed (Figure 19). Consequently, the circuitry active areas 9 and the array active areas 17 are freed and can undergo standard fabrication steps. In particular, in the array active areas 17 respective nonvolatile-memory cells 21, here of a flash type, are formed, while in the circuitry active area 9 a control circuit 22 is made, which comprises for example a read/write circuit and decoding circuits of a known type. For reasons of simplicity, in Figure 11 the cells 21 are represented as nonvolatile cells and the control circuit 22 is represented in the form of active and passive electrical components.

Figure 12, in which parts that are the same as the ones already shown are designated by the same reference numbers, illustrates a different embodiment of the invention. According to the variant, after the first thermal oxidation, a silicon-nitride film 23 is deposited on top of the first sidewalls 12 which delimit the circuitry trenches 8, by using standard CVD techniques. In this way, when the wafer 1 is subjected to the new thermal oxidation, a silicon-dioxide growth layer 12" is formed on top of the film 23, thus remaining separate from the first sidewalls 12. Consequently, the underlying silicon does not undergo any oxidation, and the effects of undesired stresses in the subsequent process steps are further limited.

The process is then completed with the steps already described previously.

The present process according to the invention affords various advantages. First, it is possible to make on one and the same semiconductor wafer trench insulating structures with differentiated characteristics. More specifically, not only trenches of different depth are made, but also insulating sidewalls with distinct thicknesses and profiles, suited to the type of circuit that is to be made in the active areas delimited by the insulating structures themselves.

Second, the fabrication steps envisaged for defining the profiles of the sidewalls of the deep trenches (circuitry trenches 8) and of the sidewalls of the shallow trenches (array trenches 16) are substantially independent of one another. Consequently, the profiles of such sidewalls can be optimized separately. In particular, the sidewalls which delimit the deeper trenches have normally a more critical geometry, have to be thicker and require more pronounced rounding; the walls that delimit the shallower trenches can, instead, be thinner. Two results are thus obtained: on the one hand, dislocations and crystallographic defects due to stress release, that usually accompany the fabrication of STI structures, are prevented; on the other hand, oversizing of the insulating structures is avoided where they are not required to bear high operating voltages and currents, and consequently the overall dimensions are reduced. Said reduction in overall dimensions is particularly marked precisely in the case of nonvolatile-storage devices. In fact, saving few tens of nanometres for each individual cell can mean a considerable reduction in the area occupied by the entire memory array, which usually comprises several million cells.

The process according to the invention is moreover very simple to implement. In fact, the process enables separate and independent optimization of the profiles of the sidewalls (and hence of the characteristics of the different trench isolation structures) without the need to add further masks with respect to the known processes which already envisage opening of isolation trenches of different depths.

Finally, it is clear that modifications and variations may be made to the device described herein, without thereby departing from the scope of the present invention.

First, as has already been mentioned previously, the process can be used for fabrication of other types of devices in addition to nonvolatile flash memories. In particular, it can be employed whenever it is necessary to integrate, on a single semiconductor wafer, devices and/or circuits which require dedicated and differently optimized insulating structures. For example, in addition to EPROM and EEPROM memories, it is possible to build devices which include circuits that handle high voltages and, at the same time, low-voltage and high-performance logic circuits.

Some steps of the process may be modified or repeated. In particular, the etching step in HF, in which the so-called undercut of the pad-oxide layer 3 is carried out can be performed, if necessary, also before the second thermal oxidation. In this case, the pad-oxide layer is removed under the silicon-nitride layer 4 all around the array trenches 16, for example, for a distance of 5 nm, so as to favour oxidation of the silicon and obtain also here sidewalls having a more rounded profile.

In addition, it is possible to envisage more than two types of isolation structures. In other words, by carrying out more than two thermal oxidation steps, sidewalls with intermediate thicknesses and different profiles and corner rounding degrees can be obtained. Each profile could in any case be optimized independently by means of dedicated thermal oxidation. In any case, the process envisages the formation first of the trenches delimited by sidewalls of greater thickness and then the formation of the other trenches delimited by sidewalls of progressively smaller thickness.

## Claims

1. A process for manufacturing semiconductor wafers incorporating differentiated insulating structures comprising the steps of:
- opening first trenches (8) in a substrate (2) of a semiconductor wafer (1), the said trenches delimiting first conductive regions (9) and having a first depth (D1); and
- opening second trenches (16), which delimit second conductive regions (17) and have a second depth (D2);
**characterized in that** said step of opening second trenches (16) is preceded by the step of forming first insulating sidewalls (12), which surround said first trenches (8), and is followed by the step of forming second insulating sidewalls (19), which surround said second trenches (16).

2. The process according to claim 1, **characterized in that** said step of forming first insulating sidewalls (12) comprises carrying out a first thermal oxidation, and said step of forming second insulating sidewalls (19) comprises carrying out a second thermal oxidation.

3. The process according to claim 2, **characterized in that** said step of forming said first insulating sidewalls (12) and said step of forming said second insulating sidewalls (19) comprise rounding of said first insulating sidewalls (12) and said second insulating sidewalls (19), respectively.

4. The process according to claim 2 or 3, **characterized in that** said first insulating sidewalls (8) have a first thickness (S1) and said second insulating sidewalls (16) have a second thickness (S2) smaller than said first thickness (S1).

5. The process according claim 4, **characterized in that** said first thickness (S1) is between approximately 25 nm and 50 nm and said second thickness (S2) is approximately 10 nm.

6. The process according to any one of the preceding claims,
**characterized in that** said step of opening first trenches (8) comprises the steps of:
- forming a protective structure (3, 4) on said wafer (1);
- making first openings (6) through said protective structure (3, 4); and
- etching said substrate (2) through said first openings (6).

7. The process according to claim 6, **characterized in that** said step of opening said second trenches (16) comprises the steps of:
- making second openings (15) through said protective structure (3, 4); and
- etching said substrate (2) through said second openings (15) .

8. The process according to claim 6 or 7, **characterized in that** said protective structure (3, 4) comprises at least one first layer (4) and one second layer (3) interposed between said first layer (4) and said substrate (2).

9. The process according to claim 8, **characterized in that**, prior to carrying out said first thermal oxidation, said second layer (3) is partially removed around said first trenches (8).

10. The process according to claim 9, **characterized in that**, prior to carrying out said second thermal oxidation, said second layer (3) is partially removed around said second trenches (16).

11. The process according to any one of the preceding claims, **characterized by** comprising the step of filling said first trenches (8) and said second trenches (16) with at least one layer of dielectric material (20).

12. The process according to any one of the preceding claims, **characterized in that** said first depth (D1) is greater than said second depth (D2).

13. A semiconductor wafer comprising first insulating structures (8, 12) and second insulating structures (16, 19), **characterized in that** said first insulating structures (8, 12) comprise first trenches (8), delimited by first insulating sidewalls (12), having a first thickness (S1), and said second insulating structures (16, 19) comprise second trenches (16), delimited by second insulating sidewalls (19) having a second thickness (S2).

14. The semiconductor wafer according to claim 13, **characterized in that** said second thickness (S2) is smaller than said first thickness (S1).

15. The semiconductor wafer according to claim 14, **characterized in that** said first thickness (S1) is between approximately 25 nm and 50 nm and said second thickness (S2) is approximately 10 nm.

16. The semiconductor wafer according to any one of claims 13 to 15, **characterized in that** said first trenches (8) have a first depth (D1) and said second trenches (16) have a second depth (D2), smaller than said first depth (D1).
